Europäisches Patentamt

European Patent Office

Office européen des brevets

(11) Veröffentlichungsnummer : **0 035 591**
**B1**

(12) **EUROPÄISCHE PATENTSCHRIFT**

(45) Veröffentlichungstag der Patentschrift :
21.03.84

(51) Int. Cl.³ : **H 03 H 11/12**

(21) Anmeldenummer : **80106941.0**

(22) Anmeldetag : **11.11.80**

(54) **Aktives NF-Bandpaßfilter.**

(30) Priorität : **11.03.80 DE 3009205**

(43) Veröffentlichungstag der Anmeldung :
**16.09.81 Patentblatt 81/37**

(45) Bekanntmachung des Hinweises auf die Patenterteilung : **21.03.84 Patentblatt 84/12**

(84) Benannte Vertragsstaaten :
**AT BE DE FR GB IT NL**

(56) Entgegenhaltungen :
**EP-A- 0 012 876
FR-A- 1 559 041
FR-A- 2 140 696
US-A- 3 715 678
US-A- 3 760 287
FUNKSCHAU, Band 49, Heft 26, Dezember 1977,
MÜNCHEN (DE) G. PICHLMAIER: "Universalfilter",
Seiten 1261-1264
INTERNATIONAL JOURNAL OF ELECTRONICS,
Band 41, Heft 4, October 1976, LONDON (GB) J.J.
HILL "Digital control of active filter characteristics",
Seiten 405-410
1969 WESCON TECHNICAL PAPERS AT WESTERN
ELECTRONIC SHOW AND CONVENTION, August 19-
22, 1969, Teil 5 "Components And Microelectronics"
NORTH HOLLYWOOD (US) D. HOLLENBECK: "Multiloop negative feedback active filters using thick film
integrated circuit technique" Vortrag 4/4, Seiten 1-5**

(73) Patentinhaber : **ROBERT BOSCH GMBH
Postfach 50
D-7000 Stuttgart 1 (DE)**

(72) Erfinder : **Bitar, Omar, Dipl.-Ing.
Kaiserdamm 111
D-1000 Berlin 19 (DE)**

(74) Vertreter : **Schmidt, Hans-Ekhardt
Robert Bosch GmbH Geschäftsbereich Elektronik
Patent- und Lizenzabteilung Forckenbeckstrasse
9-13
D-1000 Berlin 33 (DE)**

## Aktives NF-Bandpaßfilter

## Technischer Hintergrund

Die Erfindung geht aus von einem aktiven NF-Bandpaßfilter nach der Gattung des Hauptanspruchs. In der europäischen Patentanmeldung EP-A1-0 012 876, veröffentlicht am 9. Juli 1980 wird ein aktives NF-Bandpaßfilter vorgeschlagen, das drei Operationsverstärker enthält, von denen einer als Umkehrstufe und die beiden anderen als Intergratoren geschaltet sind. Von den die Mittenfrequenz des Bandpaßfilters bestimmenden Bauelementen wird zum Einstellen der Mittenfrequenz lediglich der elektrische Wert eines Bauelementes verändert.

Eine entsprechende Schaltung, die als Universalfilter (Hochpaß, Tiefpaß, Bandpaß, Bandsperre) verwendet wird, ist in der Zeitschrift Funkschau 1977, Heft 26, Seiten 1261-1264 angegeben, wobei dem Eingang des Filters ein weiterer Operationsverstärker vorgeschaltet ist, der jedoch keine Begrenzerfunktion erfüllen soll.

## Vorteile der Erfindung

Das erfindungsgemäße aktive NF-Bandpaßfilter mit den kennzeichnenden Merkmalen des Hauptanspruchs hat darüber hinaus den Vorteil, daß eine Begrenzung des Eingangssignales des Filters durch einen vorgeschalteten Begrenzerberstärker erfolgt.

Das erfindungsgemäße NF-Bandpaßfilter wird insbesondere in sogenannten Mehrtonfolge-Selektivrufsystemen eingesetzt. Bei diesem System kennzeichnet eine mehrstellige Tonfolge, zum Beispiel eine Fünf-Tonfolge, einen Teilnehmer am Sprechfunkverkehr. In besonders bevorzugter Ausgestaltung der Erfindung wird nun das erfindungsgemäße Filter im Rückkopplungszweig eines Verstärkers, etwa des Begrenzerverstärkers, angeordnet, so daß nicht nur ein Empfangen und Erkennen der Mehrtonfolge, sondern auch ein Aussenden der Mehrtonfolge mit derselben frequenzbestimmenden Schaltung möglich ist. Durch diese Doppelfunktion des erfindungsgemäßen Filters ergibt sich ein besonders wirtschaftlicher Aufbau eines derartigen Selektivrufsystems.

## Zeichnung

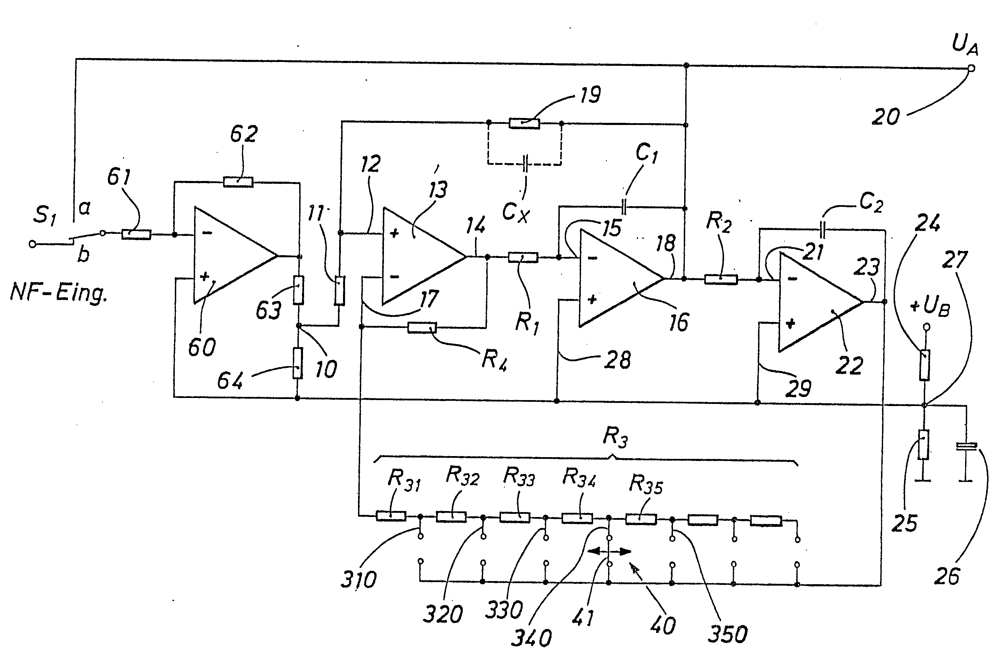

Die Erfindung ist in der Zeichnung dargestellt und in der nachfolgenden Beschreibung näher erläutert. Die einzige Figur zeigt ein Schaltbild eines erfindungsgemäßen, stufenweise umschaltbaren NF-Bandpaßfilters.

## Beschreibung der Erfindung

Bei dem in der Figur dargestellten Ausführungsbeispiel eines erfindungsgemäßen aktiven NF-Bandpaßfilters sind drei Operationsverstärker 13, 16, 22 in Reihe geschaltet, wobei die Mittenfrequenz des so entstehenden Bandpaßfilters durch ein einziges frequenzbestimmendes Element, nämlich den Widerstand R3, bestimmt wird. Durch Variation von R3 können auf diese Weise unterschiedliche Mittenfrequenzen eingestellt werden. Die In der Figur dargestellte Schaltung ist bezüglich ihrer Elemente 10 bis 41 in der älteren Patentanmeldung EP-A1-0 012 876 im einzelnen beschrieben, worauf hier Bezug genommen wird.

Dem Eingang 10 des aktiven NF-Bandpaßfilters ist ein Begrenzerverstärker vorgeschaltet, der aus einem Operationsverstärker 60 besteht, an dessen invertierenden Eingang ein Eingangswiderstand 61 angeschlossen ist, wobei der invertierende Eingang über einen Gegenkopplungswiderstand 62 mit dem Ausgang verbunden ist. Der nichtinvertierende Eingang des Operationsverstärkers 60 ist über einen Spannungsteiler 63, 64 mit dem Ausgang verbunden, wobei der Abgriff des Spannungsteilers 63, 64 an den Eingang 10 des aktiven NF-Bandpaßfilters angeschlossen ist. Im Eingang des Begrenzer-Vorverstärkers 60 bis 64 ist dem Eingangswiderstand 61 ein Schalter $S_1$ vorgeschaltet, der zwei Schaltstellungen a und b aufweist. In der Schalterstellung b ist der Eingang des Begrenzer-Vorverstärkers 60 bis 64 mit einem NF-Eingang verbunden, in der Schalterstellung a mit dem Ausgang des Operationsverstärkers 16.

In der Schalterstellung b wird auf den Begrenzer-Vorverstärker 60 bis 64 ein NF-Eingangssignal geleitet, in dem bei Verwendung in einem Tonrufsystem der Tonruf enthalten ist. Wie in der älteren Patentanmeldung EP-A1-0 012 876 beschrieben, wird durch das aktive NF-Bandpaßfilter der Erfindung die empfangene Tonfolge verarbeitet, wobei durch Umschalten des Schalters 40, 41 die jeweiligen Töne erkannt werden.

Die Vorschaltung des Begrenzer-Vorverstärkers 60 bis 64 in der Schalterstellung b des Schalters $S_1$ bewirkt dabei, daß durch Herunterteilung des Ausgangssignales des Operationsverstärkers 60 durch den Spannungsteiler 63, 64 dem nachfolgenden NF-Bandpaßfilter eine möglichst konstante Eingangsspannung geliefert wird, so daß sich hierdurch eine weitere Stabilisierung der Ausgangsspannung des Filters über den gesamten Frequenzbereich bei konstanter Güte ergibt.

In der Schalterstellung a des Schalters $S_1$ erfolgt eine Rückkopplung des Ausgangssignales des Operationsverstärkers 16 auf den invertierenden Eingang des Operationsverstärkers 60, so daß die Schaltung nun als Oszillator arbeitet, wobei die Oszillatorfrequenz gleich der Mittenfrequenz des Bandpaßfilters ist. Auch bei dieser Betriebsweise erfolgt die Abstimmung des Oszillators mit einem einzigen Widerstand, nämlich dem Widerstand R3 oder auch dem Widerstand R4. Der Frequenzbereich des Oszillators erstreckt sich dabei über den gesamten Tonruffrequenzbereich. Auch weist der so entstandene Oszillator eine konstante Ausgangsspannung über den gesamten Frequenzbereich auf.

Werden für die Operationsverstärker 13, 16, 22 mittelschnelle Ausführungen verwendet, so bleiben die Güte des NF-Bandpaßfilters und dessen Ausgangsspannung innerhalb des gewählten Frequenzbereiches nicht konstant. Aus diesem Grunde ist es erforderlich, dem Widerstand 19 einen Kondensator $C_x$ kleinen Kapazitätswertes parallelzuschalten. Da die Güte durch das Verhältnis der Widerstandswerte der Widerstände 19 und 11 bestimmt ist und die Güte mit zunehmender Frequenz ansteigt, bewirkt der Kondensator $C_x$ eine Kompensation dieses Effekts, so daß die Güte weitgehend konstant bleibt. Die Ausgangsspannung $U_A$ läßt sich mit einem RC-Glied leicht korrigieren.

## Ansprüche

1. Aktives NF-Bandpaßfilter mit einer Reihenschaltung aus einem ersten Operationsverstärker (13), der als Umkehrverstärker geschaltet ist, und einem zweiten (16) und einem dritten Operationsverstärker (22), die als Integratoren geschaltet sind, wobei zwei Kondensatoren (C1, C2) und vier Widerstände (R1, R2, R3, R4) die Mittenfrequenz des Bandpaßfilters bestimmen, von denen der erste Widerstand (R1) zwischen dem Ausgang (14) des ersten (13) und einem Eingang (15) des zweiten Operationsverstärkers (16), der zweite Widerstand (R2) zwischen dem Ausgang (18) des zweiten (16) und einem Eingang (21) des dritten Operationsverstärkers (22), der dritte Widerstand (R3) zwischen dem Ausgang (23) des dritten (22) und einem Eingang (17) des ersten Operationsverstärkers (13) und der vierte Widerstand (R4) zwischen dem Ausgang (14) und dem Eingang (17) des ersten Operationsverstärkers (13) liegen, und wobei ferner die Mittenfrequenz des Bandpaßfilters durch Verändern des Widerstandswertes des dritten Widerstandes (R3) oder des vierten Widerstandes (R4) innerhalb eines Frequenzbereiches, dessen untere und obere Grenzfrequenz um etwa den Faktor 3 differieren, bei einer bestimmten Dimensionierung der frequenzbestimmenden Bauelemente ohne merkliche Änderung der Güte und der Ausgangsspannung des Bandpaßfilters einstellbar ist, dadurch gekennzeichnet, daß dem Bandpaßfilter ein Begrenzer-Vorverstärker (60 bis 64) vorgeschaltet ist, dessen Eingang wahlweise eine NF-Spannung oder die Ausgangsspannung ($U_A$) des Bandpaßfilters zugeführt wird.

2. Aktives Bandpaßfilter nach Anspruch 1, dadurch gekennzeichnet, daß für die Dimensionierung der frequenzbestimmenden Bauelemente ($C_1$, $C_2$, $R_1 \dots R_4$) folgende Beziehungen gelten :

(1) $C_1 = C_2 = C \simeq (4\,200 \cdot 10^{-9})/f_{max}$ ($f_{max}$ = obere Grenzfrequenz)
(2) $R_1 = R_2 = R = 1/(f_{max} \cdot \pi \cdot C)$
(3) $R_4 \simeq R/7{,}5$ (wenn mit $R_3$ abgestimmt wird)
(4) $R_3 = R_4/(2 \cdot \pi \cdot R \cdot C \cdot f_M)^2$ ($f_M$ = Mittenfrequenz)
(5) $R_3 \simeq R/7{,}5$ (wenn mit $R_4$ abgestimmt wird)
(6) $R_4 = R_3 \cdot (2 \cdot \pi \cdot R \cdot C \cdot f_M)^2$.

3. Aktives Bandpaßfilter nach Anspruch 1 oder 2, dadurch gekennzeichnet, daß zwecks stufenweiser Einstellung der Mittenfrequenz ($f_M$) des Bandpaßfilters der Widerstand ($R_3$ oder $R_4$) aus einer Reihenschaltung mit mindestens zwei Widerständen ($R_{31}$, $R_{32}$ ...) besteht, daß zwischen je zwei benaxhbarten Widerständen ($R_{31}$, $R_{32}$) der Reihenschaltung ein Abgriff (310, 320 ...) vorgesehen ist und daß jeweils ein der gewünschten Mittenfrequenz ($f_M$) entsprechender Abgriff mittels einer Schalteinrichtung (40) auswählbar ist.

4. Aktives Bandpaßfilter nach Anspruch 1 oder 2, dadurch gekennzeichnet, daß zwecks kontinuierlicher Einstellung der Mittenfrequenz ($f_M$) des Bandpaßfilters ein Einstellwiderstand vorgesehen ist.

5. Aktives Bandpaßfilter nach einem der Ansprüche 1 bis 4, gekennzeichnet durch die Anwendung bei einem Mehrtonfolge-Selektivrufsystem.

6. Aktives Bandpaßfilter nach Anspruch 1 oder 2, dadurch gekennzeichnet, daß der Ausgang (18) des zweiten Operationsverstärkers (16) über einen Widerstand (19) mit dem nichtinvertierenden Eingang (12) des ersten Operationsverstärkers (13) verbunden ist und daß dem Widerstand ein Kondensator ($C_x$) kleinen Kapazitätswertes parallelgeschaltet ist.

## Claims

1. An active low frequency bandpass filter comprising a series combination of a first operational amplifier (13) which is connected as an inverting amplifier and a second (16) and third operational amplifier (22) which are connected as integrators, the mean frequency of the bandpass filter being determined by two capacitors (C1, C2) and four resistors (R1, R2, R3, R4), the first resistor (R1) being located between the output (14) of the first operational amplifier (13) and an input (15) of the second operational amplifier (16), the second resistor (R2) being located between the output (18) of the second operational amplifier (16) and an input (21) of the third operational amplifier (22), the thrid resistor (R3) being located between the output (23) of the third operational amplifier (22) and an input (17) of the first operational amplifier (13), and the fourth resistor (R4) being located between the output (14) and the input (17) of the first operational amplifier (13), and the mean frequency of the bandpass filter being adjustable by varying the resistance value of the third resistor (R3) or of the fourth resistor (R4) within a frequency range whose lower and upper limiting frequencies differ by approximately the factor 3, with a specific dimensioning of the frequency-determining components without a perceptible change in the quality and the output voltage of the bandpass filter, characterised in that there is connected in series with the bandpass filter a limiting preamplifier (60 to 64) to the input of which is selectively fed an LF frequency or the output voltage ($U_A$) of the bandpass filter.

2. An active bandpass filter as claimed in claim 1, characterised in that the following equations apply to the dimensioning of the frequency-determining compoments ($C_1$, $C_2$, $R_1$ ... $R_4$) :

(1) $C_1 = C_2 = C \simeq (4\,200 \cdot 10^{-9})/f_{max}$ ($f_{max}$ = upper limiting frequency)
(2) $R_1 = R_2 = R = 1/(f_{max} \cdot \pi \cdot C)$
(3) $R_4 \simeq R/7.5$ (when adjusting with $R_3$)
(4) $R_3 = R_4/(2 \cdot \pi \cdot R \cdot C \cdot f_M)^2$ ($f_M$ = mean frequency)
(5) $R_3 \simeq R/7.5$ (when adjusting with $R_4$)
(6) $R_4 = R_3 \cdot (2 \cdot \pi \cdot R \cdot C \cdot f_M)^2$.

3. An active bandpass filter as claimed in claim 1 or 2, characterised in that the resistor ($R_3$ or $R_4$) comprises a series combination of at least two resistors ($R_{31}$, $R_{32}$ ...) for the purpose of stepwise adjustment of the mean frequency ($f_M$) of the bandpass filter, that a tapping (310, 320 ...) is provided between each two adjacent resistors ($R_{31}$, $R_{32}$) of the series combination, and that a respective tapping corresponding to the desired mean frequency ($f_M$) is selectable by means of a switching device (40).

4. An active bandpass filter as claimed in claim 1 or 2, characterised in that an adjustable resistor is provided for the purpose of continuous adjustment of the mean frequency ($f_M$) of the bandpass filter.

5. An active bandpass filter as claimed in one of the claims 1 to 4, characterised by its use in a multitone-sequence selective call system.

6. An active bandpass filter as claimed in claim 1 or 2, characterised in that the output (18) of the second operational amplifier (16) is connected to the non-inverting input (12) of the first operational amplifier (13) by way of a resistor (19), and that a capacitor ($C_x$) having a low capacitance value is connected in parallel with the resistor.

## Revendications

1. Filtre passe-bande actif à basse fréquence avec un montage en série constitué par un premier amplificateur opérationnel (13) branché en amplificateur inverseur, et d'un second (16) ainsi que d'un troisième (22) amplificateurs opérationnels, qui sont branchés en intégrateurs, deux condensateurs (C1, C2) et quatre résistances (R1, R2, R3, R4) déterminant la fréquence moyenne du filtre passe-bande, la première résistance (R1) étant placée entre la sortie (14) du premier amplificateur opérationnel (13) et une entrée (15) du second amplificateur opérationnel (16), la seconde résistance (R2) étant placée entre la sortie (18) du second amplificateur opérationnel (16) et une entrée (21) du troisième amplificateur opérationnel (22), la troisième résistance (R3) étant placée entre la sortie (23) du troisième amplificateur opérationnel (22) et une entrée (17) du premier amplificateur opérationnel (13), et la quatrième résistance (R4) étant placée entre la sortie (14) et l'entrée (17) du premier amplificateur opérationnel (13), tandis qu'en outre, la fréquence moyenne du filtre passe-bande est susceptible d'être réglée par modification de la valeur de résistance de la troisième résistance (R3) ou bien de la quatrième résistance (R4) à l'intérieur d'une gamme de fréquences dont les fréquences limites inférieure et supérieure diffèrent d'environ le facteur 3, pour un dimensionnement déterminé des composants déterminant la fréquence, sans modification notable de la qualité et de la tension de sortie du filtre passe-bande caractérisée en ce qu'un préamplificateur de limitation (60 à 64) est branché en amont de ce filtre passe-bande, une tension basse fréquence ou bien la tension de sortie ($U_A$) du filtre passe-bande étant appliquée au choix à l'entrée de ce préamplificateur.

2. Filtre passe-bande actif selon la revendication 1, caractérisé en ce que pour le dimensionnement des composants déterminant la fréquence ($C_1$, $C_2$, $R_1$ ... $R_4$), les relations suivantes sont valables :

(1) $C_1 = C_2 = C \simeq (4\,200 \cdot 10^{-9})/f_{max}$ ($f_{max}$ = fréquence limite supérieure)
(2) $R_1 = R_2 = R = 1/(f_{max} \cdot \pi \cdot C)$
(3) $R_4 \simeq 4/7,5$ (si l'accord se fait avec $R_3$)
(4) $R_3 = R_4/(2 \cdot \pi \cdot R \cdot C \cdot f_M)^2$ ($f_M$ = fréquence moyenne)
(5) $R_3 \simeq 4/7,5$ (si l'accord se fait avec $R_4$)
(6) $R_4 = R_3 \cdot (2 \cdot \pi \cdot R \cdot C \cdot f_M)^2$.

4

3. Filtre passe-bande actif selon l'une des revendications 1 ou 2, caractérisé en ce que, pour régler par paliers la fréquence moyenne ($f_M$) du filtre passe-bande, la résistance ($R_3$ ou bien $R_4$) est constituée par un montage en série d'au moins deux résistances ($R_{31}$, $R_{32}$ ...), une prise (310, 320 ...) étant prévue entre respectivement deux résistances voisines ($R_{31}$, $R_{32}$) du montage en série, cependant qu'une prise correspondant respectivement à la fréquence moyenne choisie ($f_M$) est susceptible d'être sélectionnée au moyen d'un dispositif de commutation (40).

4. Filtre passe-bande actif selon l'une des revendications 1 ou 2, caractérisé en ce que, pour le réglage en continu de la fréquence moyenne ($f_M$) du filtre passe-bande, il est prévu une résistance réglable.

5. Filtre passe-bande actif selon l'une quelconque des revendications 1 à 4, caractérisé en ce qu'il est utilisé pour un système d'appel sélectif à succession de tonalités multiples.

6. Filtre passe-bande actif selon l'une des revendications 1 ou 2, caractérisé en ce que la sortie (18) du second amplificateur opérationnel (16) est reliée par l'intermédiaire d'une résistance (19) avec l'entrée non inversée (12) du premier amplificateur opérationnel (13), tandis qu'un condensateur ($C_x$) de faible valeur de capacité est branché en parallèle sur cette résistance.

$U_A$ · 20 · 24 · 27 · $+U_B$ · 26 · 25 · $C_2$ · 23 · 21 · 22 · 29 · $R_2$ · 18 · 16 · $C_1$ · 15 · 28 · 19 · $C_x$ · $R_1$ · 14 · 13 · 12 · 17 · $R_4$ · $R_3$ · $R_{35}$ · $R_{34}$ · $R_{33}$ · $R_{32}$ · $R_{31}$ · 350 · 40 · 41 · 340 · 330 · 320 · 310 · 11 · 10 · 63 · 64 · 62 · 60 · 61 · $S_1$ · a · b · NF-Eing.